Europäisches Patentamt

European Patent Office

Office européen des brevets

(11) Publication number: **0 253 555**
**A2**

## EUROPEAN PATENT APPLICATION

(21) Application number: 87305986.9

(22) Date of filing: 07.07.87

(51) Int. Cl.4: **H03K 19/003** , H03K 17/22

(30) Priority: 08.07.86 JP 160268/86

(43) Date of publication of application:
20.01.88 Bulletin 88/03

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Enomoto, Hiromu
5349 Kachime-cho
Sendai-shi Kagoshima 895(JP)
Inventor: Yasuda, Yasushi
Tama Inagi Manshon 2-510 536-5, Omaru
Inagi-shi Tokyo 206(JP)
Inventor: Kumagai, Masao
Mitsunaga Manshon 303 1047-1,
Mukoudamachi
Sendai-shi Kagoshima 895(JP)
Inventor: Tahara, Akinori
7-15-25, Kotsubo
Zushi-shi Kanagawa 249(JP)

(74) Representative: Billington, Lawrence Emlyn et
al
HASELTINE LAKE & CO Hazlitt House 28
Southampton Buildings Chancery Lane
London WC2A 1AT(GB)

(54) Logic circuit employing bipolar-transistors and stable upon starting-up of power supply therefor.

(57) A logic circuit employing bipolar-transistors and including a level-shift circuit unit, in addition to a normal bipolar logic circuit, for improving a stability of the circuit upon start-up of a power supply. The logic circuit includes: an input circuit (I) receiving at least one input signal (SIN) and connected to a terminal of a power supply; a first internal circuit including a first bipolar transistor (T3), a base of which is connected to an output of the input circuit, and a level-shift circuit (D2) connected between a terminal of the first bipolar transistor and another terminal of the power supply; a level-shift circuit unit (3) connected between the terminal of the power supply and another terminal of the first bipolar transistor; a second internal circuit including a second bipolar transistor (T4) a base of which is connected to a commonly-connected point of the level-shift circuit unit and another terminal of the first bipolar transistor; and an output circuit means including a third bipolar transistor (T5) a base of which is connected to an output terminal of the second bipolar transistor, a terminal of which is connected to another terminal of the power supply and another terminal of which is provided for connection to a load circuit. A forward voltage of the level-shift circuit unit, the second internal circuit and the output circuit is higher than a forward voltage of the first internal circuit. The first to third bipolar transistors have the same operational polarities.

*Fig. 3*

# LOGIC CIRCUIT EMPLOYING BIPOLAR-TRANSISTORS AND STABLE UPON STARTING-UP OF POWER SUPPLY THEREFOR

## BACKGROUND OF THE INVENTION

### I. Field of the Invention

The present invention relates to a logic circuit. More particularly, it relates to a logic circuit employing bipolar-transistors which is stable when a power supply therefor is started-up.

The logic circuit of the present invention can be employed for a buffer circuit, a logic gate circuit, etc.

### 2. Description of the Related Art

Logic circuits employing bipolar transistors are well known. However, those logic circuits suffer from a disadvantage in that a malfunction often occurs when a power supply therefor is started-up. This malfunction will be described in detail with reference to a specific example.

## SUMMARY OF THE INVENTION

An object of the present invention is to provide a logic circuit employing bipolar transistors which is stable when a power supply therefor is started-up.

According to the present invention, there is provided a logic circuit including: an input circuit receiving at least one input signal and connected to a terminal of a power supply; a first internal circuit, operatively connected to the input circuit including a first bipolar transistor, a base of which is connected to an output of the input circuit, and a level-shift circuit connected between a terminal of the first bipolar transistor and another terminal of the power supply; a level-shift circuit unit connected between the terminal of the power supply and another terminal of the first bipolar transistor; a second internal circuit, operatively connected between the terminals of the power supply and including a second bipolar transistor, a base of which is connected to a commonly-connected point of the level-shift circuit unit and the another terminal of the first bipolar transistor; and an output circuit, operatively connected to the second internal circuit and including a third bipolar transistor, a base of which is connected to an output terminal of the second bipolar transistor, a terminal of which is connected to another terminal of the power supply and another terminal of which is provided for connection to a load circuit. The first to third bipolar transistors may have the same operational polarities.

A forward voltage of the level-shift circuit unit, the second internal circuit, and the output circuit is higher than a forward voltage of the first internal circuit.

## BRIEF DESCRIPTION OF THE DRAWINGS

Other objects and features of the present invention will be described below in detail with reference to the accompanying drawings, in which:

Fig. I is a circuit diagram of a prior art logic circuit;

Fig. 2 is a graph illustrating the operation of the logic circuit of Fig. I upon start-up of a power supply;

Fig. 3 is a circuit diagram of an embodiment of a logic circuit according to the present invention;

Fig. 4 is a graph illustrating the operation of the logic circuit in Fig. 3 upon start-up of the power supply;

Figs. 5a to 5d are timing charts illustrating the operation of transistors T2 to T5 in Fig. 3 upon start-up of the power supply; and

Figs. 6 to 8 are circuit diagrams of second to fourth embodiments of logic circuits in accordance with the present invention.

## DESCRIPTION OF THE PREFERRED EMBODIMENTS

Before describing the preferred embodiments of the present invention, an example of a prior art logic circuit is described with reference to the drawings for comparison.

Referring to Fig. I, a prior art logic circuit employing a buffer circuit (well known as the 74 series) includes an input PNP-type bipolar transistor TI, a base of which receives an input signal SIN, a collector of which is grounded, and an emitter of which is connected to a power supply of a voltage $V_{CC}$ through a resistor RI; a level-shift NPN-type Schottky-clamped transistor T2, a base of which is connected to the emitter of the transistor TI, a collector of which is connected to the power supply $V_{CC}$ through a resistor R2, and an emitter of which is grounded through a resistor R5; and a speed-up Schottky-barrier diode DI. The above circuit elements form an input circuit I. The diode DI func-

tions as a coupling capacitor transmitting a change of the input signal SIN to the base of the transistor T3, and accordingly, speeding-up the operation of the transistor T3. The resistor R5 brings the transistor T2 to an active ON state on the basis of a voltage drop thereat, speeding-up the operation of the transistor T2.

The logic circuit of Fig. I also includes an NPN-type Schottky-clamped transistor T3, a base of which is connected to the emitter of the transistor T2, a collector of which is connected to the power supply $V_{CC}$ through a resistor R3, and an emitter of which is grounded through a level-shift diode D2. The logic circuit of Fig. I further includes a level-shift NPN-type Schottky-clamped transistor T4, a base of which is connected to the collector of the transistor T3, a collector of which is connected to the power supply $V_{CC}$ through a resistor R4, and an emitter of which is grounded through a resistor R6. The logic circuit includes an open-collector type output NPN Schottky-clamped transistor T5, a base of which is connected to the emitter of the transistor T4 and an emitter of which is grounded.

When the logic circuit is employed for a buffer circuit, a load circuit 2, for example, an IC logic circuit, and a pull-up resistor $R_{PL}$ can be connected to a collector of the transistor T5.

In a normal operational state, when the input signal SIN is high level an output level of the output signal SOUT at the collector of the output transistor T5 is high level, and vice versa.

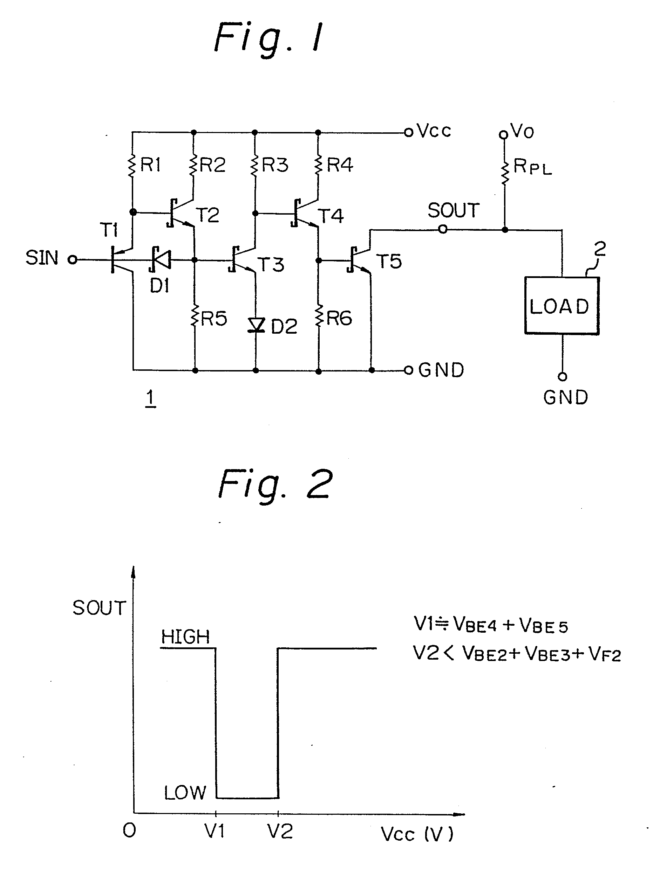

The operation of the logic circuit upon a start-up of the power supply will be described with reference to Fig. 2.

When the power supply is turned OFF, and thus the voltage $V_{CC}$ thereof is at ground level, upon transmission of the high level input signal SIN, the transistors T2, T3, T4 and T5 are OFF, and accordingly, the output signal SOUT is high level because of an outside voltage $V_0$. When the voltage $V_{CC}$ of the power supply is raised to a voltage $VI = V_{BE4} + V_{BE5}$, where $V_{BE4}$ denotes a voltage between the base and emitter of the transistor T4 and $V_{BE5}$ denotes a voltage between the base and emitter of the transistor T5, the transistor T4, and accordingly the transistor T5, are turned ON, lowering the output signal SOUT. When the voltage $V_{CC}$ is further raised to a voltage $V2 < V_{BE2} + V_{BE3} + V_{F2}$, where $V_{BE2}$ denotes a voltage between the base and emitter of the transistor T2, $V_{BE3}$ denotes a voltage between the base and emitter of the transistor T3, and $V_{F2}$ denotes a forward voltage of the diode D2, the transistors T2 and T3 are turned ON and thus the transistors T4 and T5 are turned OFF, and accordingly, the output signal SOUT is high level.

As seen from the above, at the transient state of the power supply, the logic circuit of Fig. I outputs a low pulse output signal SOUT between the voltages VI and V2 when the input signal SIN is high level, and vice versa. This undesirable pulse has an adverse affect on the logic IC circuit 2.

An undesirable pulse may be generated not only upon a start-up or restart-up of the power supply, but also when a printed circuit board having the logic circuit of Fig. I mounted thereon is inserted into a receptacle after extraction, during, for example, maintenance or inspection of the printed circuit board.

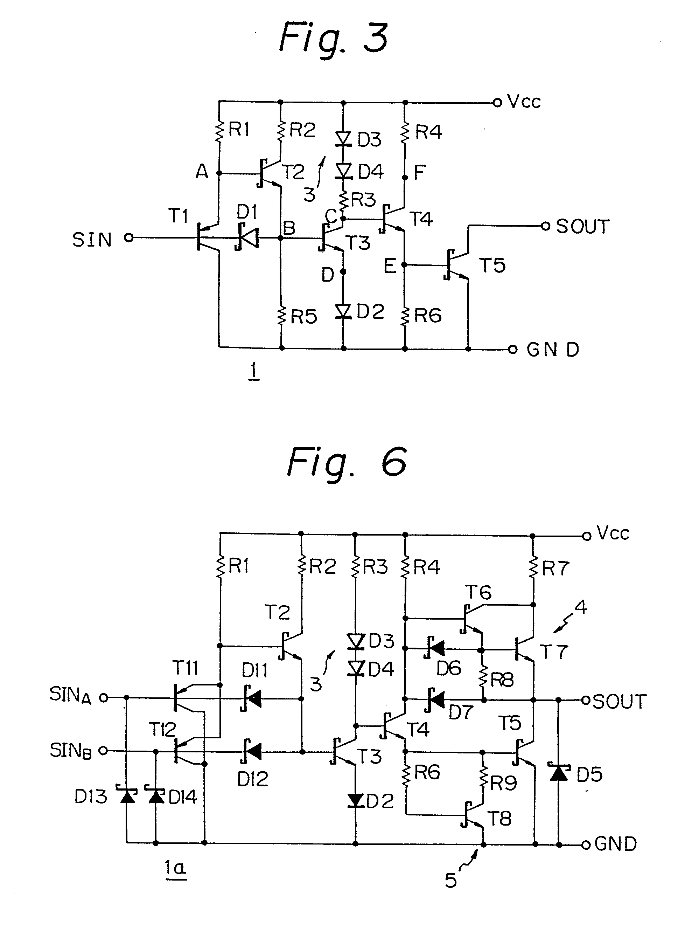

Now, a first embodiment of the present invention will be described with reference to Fig. 3.

A logic circuit shown in Fig. 3 is provided with a level-shift circuit 3 consisting of series-connected diodes D3 and D4 between the resistor R3 at the collector of the transistor T3 and the power supply, in addition to the logic circuit of Fig. I. Other circuit elements of the logic circuit of Fig. 3 are substantially identical to those in Fig. I.

The level-shift circuit 3 is provided to enable an increase in a forward voltage VFI for the transistors T4 and T5 to a level higher than another forward voltage VF2 for the transistors T2 and T3. Therefore, due to the provision of the level-shift circuit 3, an unstable operation of the output transistor T5 is avoided upon a start-up of the power supply, as will be seen later.

The start-up operation of the logic circuit of Fig. 3 will be described while using the following specific parameters:

a. forward voltages of the diodes D2, D3 and D4

$V_{F2} = V_{F3} = V_{F4} = 0.8$ V

b. normal threshold voltages of the transistors T2 to T5

$V_{TH} - V_{TH2} = V_{TH3} = V_{TH4} = V_{TH4} = V_{TH5} = 0.8$ V active ON threshold voltages:

$V'_{TH} = 0.6$ V

c. resistance values of the resistors RI to R6

RI = 40 kΩ
R2 = 60 kΩ
R3 = 20 kΩ
R4 = I5 kΩ
R5 = 60 kΩ
R6 = 6 kΩ

d. rated voltage $V_{CC}$ of the power supply $V_{CC}$ = 5 V

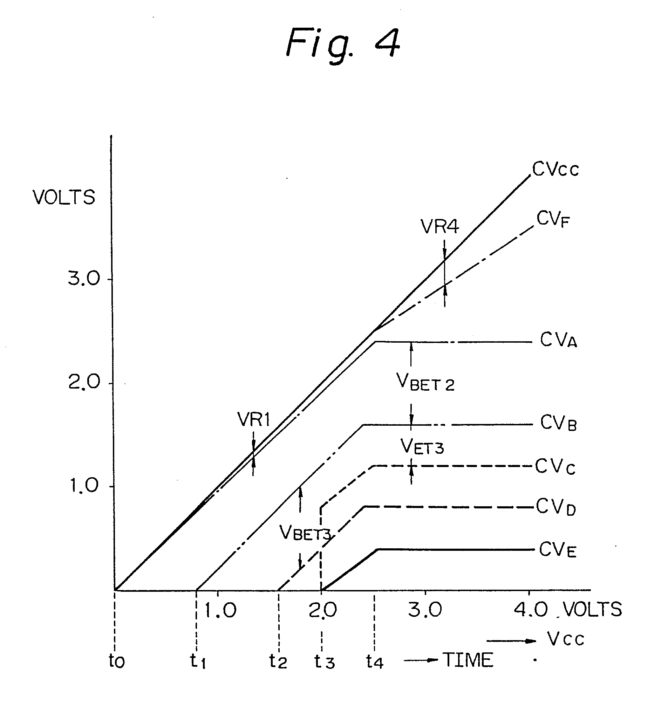

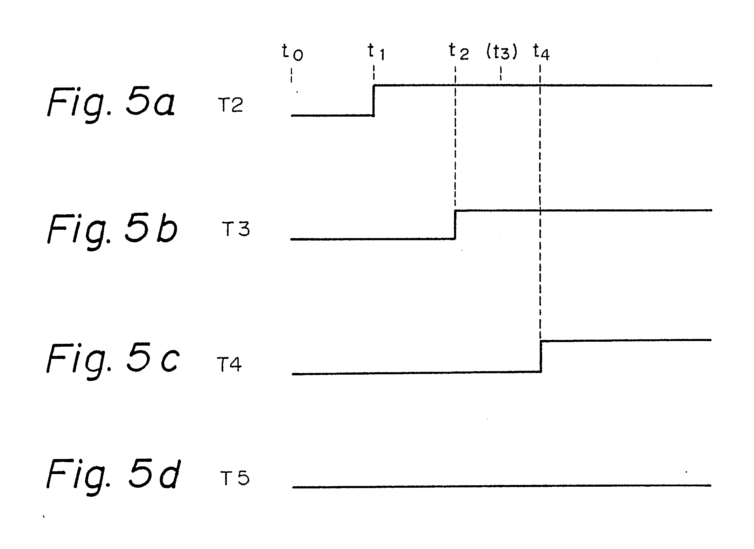

First, the start-up operation of the logic circuit when the input signal SIN is high level will be described with reference to Figs. 4 and 5a to 5d.

In Fig. 4, a line $V_{CC}$ indicates the rise of the voltage $V_{CC}$ of the power supply, and curves $CV_A$, $CV_B$, $CV_C$, $CV_D$, $CV_E$ and $CV_F$ indicate voltage changes $V_A$, $V_B$, $V_C$, $V_D$, $V_E$ and $V_F$ at nodes A, B, C, D, E, and F in Fig. 3. Figures 5a to 5d are timing charts of the operations of the transistors T2 to T5.

At a time $t_0$ the transistor Tl is inversion-biased between the base and the emitter thereof, and thus the transistor T2 and the transistor T3 are turned OFF. The diode D2 is nonconductive.

When the voltage $V_{CC}$ is increased, the voltage $V_A$ is increased, but remains lower than the voltage $V_{CC}$ by a voltage drop VRl at the resistor Rl. When the voltage $V_A$ reaches approximately 0.8 V, corresponding to the threshold voltage of the transistor T2 at a time $t_1$, the transistor T2 is turned ON (Fig. 5a).

A current then flows through the collector•emitter of the transistor T2, the base•emitter of the transistor T3, and the diode D2, and is increased in response to the rise of the voltage $V_{CC}$, and accordingly, raises the voltage $V_B$. The voltage $V_B$ is lower than the voltage $V_A$ by the voltage $V_{BET2}$, which is a voltage between the base and the emitter of the transistor T2. The voltages $V_A$ and $V_B$ are determined by the following formulas:

$$V_A = V_{BET2} + V_{BET3} + V_{FD2} \quad \ldots (l)$$
$$V_B = V_A - V_{BET2}$$
$$= V_{BET3} + V_{FD2} \quad \ldots (2)$$

When the voltage $V_B$ exceeds approximately l.6 V at a time $t_2$, in other words, the voltage $V_{CC}$ becomes higher than $(V_{BET2} + V_{BET3} + V_{FD2})$, the transistor T3 is turned ON. The diode D2 also becomes conductive. The voltage $V_D$ is lower than the voltage $V_B$ by the voltage $V_{BET3}$.

When the transistor T3 is turned ON, a current flows through the series-diodes D3 and D4, the resistor R3, the collector•emitter of the transistor T3, and the diode D2.

$$V_C = V_B - V_{FT3}$$
$$= V_{BET3} + v_{FD2} - V_{FT3} \ldots (3)$$

where, $V_{FT3}$ indicates a forward voltage of the transistor T3.

As the voltage $V_{CC}$ reaches approximately 2.0 V at a time $t_3$, the voltage $V_{CC}$ at the base of transistor T4 is abruptly increased on the basis of the Schottky-clamped diode characteristics of the transistor T3.

As the voltage $V_D$ reaches the forward voltage of the diode D2 $V_{F2}$ of approximately 0.8 V at a time t4, in other words, the voltage $V_{CC}$ reaches approximately 2.4 V, the voltage $V_C$ at the base of the transistor T4 is increased to approximately l.2 V. The voltage $V_C$ of l.2 V is sufficient to turn ON the transistor T4, and then the transistor T4 is brought to the active ON state at the time $t_3$. As a result, a current flows through the resistor R4, the collector•emitter of the transistor T4, and the resistor R6.

The voltage $V_E$ is expressed by the following formula:

$$V_E = V_C - V_{BET4} \quad \ldots (4)$$

At this time, $V_C \simeq l.2$ V, $V_{BET4} \simeq 0.8$ V, then the voltage $V_E$ becomes 0.4 V. The voltage $V_E$ is insufficient to turn ON the transistor T5, and in order to turn the transistor T5 ON, the voltage $V_{CC}$ must be higher than the voltage $(V_{FD3} + V_{FD4} + V_{BET4} + V_{BET3}) \simeq 3.2$ V, but a current voltage $V_{CC}$ is approximately 2.4 V. Accordingly, the output transistor T5 is kept OFF.

After the time $t_3$ has elapsed, the voltage $V_F$ is increased in response to the rise of the voltage $V_{CC}$, but is lower than the voltage $V_{CC}$ by a voltage drop VR4 at the resistor R4. Other voltages $V_A$, $V_B$, $V_C$, $V_D$ and $V_E$ are saturated at predetermined levels, determined by the forward voltage of the transistor and/or the diode and the voltage drop at the resistor, respectively.

As can be understood from the above description, undesirable operation of the output transistor T5 is avoided during the start-up of the power supply.

If the pull-up resistor $R_{PL}$ and the load 2 are connected to the collector of the transistor T5, as shown in Fig. l, the output signal SOUT is high level.

Next, the start-up operation of the logic circuit of Fig. 3 when the input signal SIN is low level will be described.

Since the input transistor Tl is turned ON during the operation of the logic circuit of Fig. 3, the voltage $V_A$ of the base at the transistor T2 is turned OFF during that operation, the transistor T3 is kept OFF, and the diode D2 is nonconductive.

When the voltage $V_{CC}$ is increased, the voltage $V_C$ at the base of the transistor T4 exceeds the voltage $V_{F3} + V_{F4} + V_{BET4}$, i.e. approximately 2.4 V, and thus the transistor T4 is turned ON. A current then flows through the series-diodes D3 and D4, the resistor R3, the base•emitter of the transistor T4, and the resistor R6 and increases the voltage $V_E$ at the base of the transistor T5 in response to the rise of the voltage $V_{CC}$.

When the voltage $V_E$ exceeds the threshold voltage $V_{TH5}$ of approximately 0.8 V, in other words, the voltage $V_{CC}$ exceeds the voltage $(V_{FD3} + V_{FD4} + V_{BET4} + V_{BET5})$ of approximately 3.2 V, the output transistor T5 is turned ON. If the pull-up resistor $R_{PL}$ and the load 2 are connected to the collector of the transistor T5, the output signal SOUT is low level.

An effective low level output signal is output after the voltage $V_{CC}$ has exceeded ($V_{FD3}$ + $V_{FD4}$ + $V_{BET4}$ + $B_{BET5}$), but the undesirable pulse output is not inhibited.

The start-up operation of the logic circuit of Fig. 3 when the base and the collector of the input transistor Tl are opened, in other words, the base is not grounded, will not be described, since this operation is similar to that when the high level input signal SIN is supplied to the base of the transistor Tl.

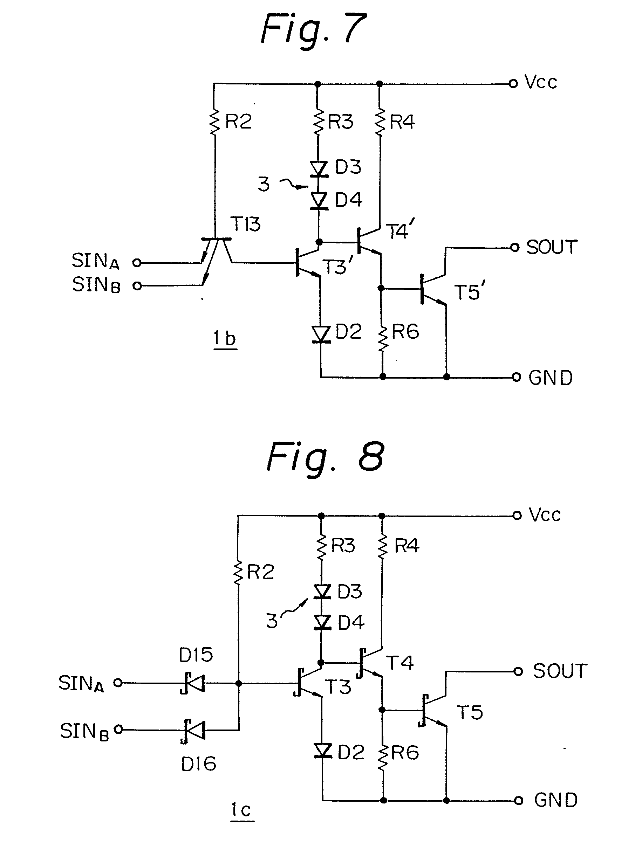

A second embodiment of the present invention will be described with reference to Fig. 6.

The logic circuit shown in Fig. 6 includes an input circuit la, an off buffer circuit 4, and an active pull-down circuit 5. The input circuit la consists of parallel-connected input PNP-type bipolar transistors Tll and Tl2, parallel-connected Schottky barrier clamping diodes Dl3 and Dl4, parallel-connected speed-up Schottky barrier diodes Dll and Dl2, the NPN-type Schottky-clamped bipolar transistor T2, and the resistors Rl and R2. The off buffer circuit 5 consists of an NPN-type Schottky-clamped bipolar transistor T6, an NPN-type bipolar transistor T7, Schottky barrier diodes D6 and D7, and resistors R7 and R8. The active pull-down circuit 5 consists of an NPN-type Schottky-clamped bipolar transistor T8, the resistor R6, and a resistor R9. In addition, the logic circuit of Fig. 6 includes a Schottky barrier diode D5 connected in parallel to the output transistor T5. Other circuit elements are substantially the same as those shown in Fig. 3.

The input circuit la functions as a two-input AND gate. The off buffer circuit 4, per se, is known as a current drive circuit for an input circuit of a TTL circuit and improves an operational margin against noise, etc., the diode D5 protects the transistor T5 against noise, and the active pull-down circuit 5 contributes to the speed-up of the transistor T4. These circuits can selectively be adopted.

As the other circuit elements in Fig. 6 are the same as those in Fig. 3, the principle of the operation discussed above is also similar, that is, the malfunction of the output signal SOUT is eliminated.

A third embodiment of the present invention will be described with reference to Fig. 7.

The logic circuit shown in Fig. 7 includes an input circuit lb, consisting of the resistor R2 and a multi-emitter NPN-type bipolar transistor Tl3, and NPN-type bipolar transistors T3', T4' and T5' instead of the NPN-type Schottky-clamped bipolar transistors T3, T4 and T5 in Fig. 3. The level-shift diode D2 for the transistor T3', the level-shift circuit 3 for the transistor T4', and the resistors R3, R4, and R6 are substantially identical to those shown in Fig. 3.

The logic circuit in Fig. 6 operates a two input AND buffer circuit, and the principle of the buffer operation is the same as that of Fig. 3.

A fourth embodiment of the present invention will be described with reference to Fig. 8.

The logic circuit shown in Fig. 6 includes an input circuit lc consisting of two Schottky barrier diodes Dl5 and Dl6 and the resistor R2. The input circuit lc also functions as a two input AND circuit. The other circuits are substantially the same as those in Fig. 3.

As shown by the variety of embodiments, by providing the level-shift circuit for the transistor T4 or T4', as the series-connected diodes D3 and D4, for increasing the base voltage of the transistor T4 or T4' to a level higher than that of the transistor T3 or T3', the logic circuit is made stable against transient changes in the voltage $V_{CC}$ of the power supply.

Many widely different embodiments of the present invention may be constructed without departing from the spirit and scope of the present invention. It should be understood that the present invention is not limited to the specific embodiments described in this specification, except as defined in the appended claims.

## Claims

l. A logic circuit comprising:

input circuit means (l) receiving at least one input signal (SIN) and connected to a terminal of a power supply;

first internal circuit means, operatively connected to said input circuit means, including a first bipolar transistor (T3), a base of which is connected to an output of said input circuit means, and a level-shift circuit (D2) connected between a terminal of said first bipolar transistor and another terminal of said power supply;

level-shift circuit means (3) connected between said terminal of the power supply and another terminal of said first bipolar transistor;

second internal circuit means, operatively connected between said terminals of said power supply, including a second bipolar transistor (T4) a base of which is connected to a commonly-connected point of said level-shift circuit means and said another terminal of said first bipolar transistor; and

output circuit means, operatively connected to said second internal circuit means, including a third bipolar transistor (T5), a base of which is connected to an output terminal of said second bipolar transistor, a terminal of which is connected to said another terminal of said power supply and another terminal of which is provided for connection to a load circuit,

said first to third bipolar transistors having similar operational polarities, and

a forward voltage of said level-shift circuit means, said second internal circuit means and said output circuit means being higher than a forward voltage of said first internal circuit means.

2. A logic circuit according to claim I, wherein said first to third bipolar transistors have similar threshold voltages.

3. A logic circuit according to claim 2, wherein said level-shift circuit means has a forward voltage at least equal to a forward voltage of said level-shift circuit in said first internal circuit means.

4. A logic circuit according to claim 3, wherein said level-shift circuit includes a diode (D2).

5. A logic circuit according to claim 4, wherein said level-shift circuit means includes at least one diode having a forward voltage equal to that of said diode in said level-shift circuit.

6. A logic circuit according to claim I, wherein said first to third transistors are NPN-type bipolar transistors.

7. A logic circuit according to claim 6, wherein said first to third NPN-type bipolar transistors are Schottky-clamped bipolar transistors.

8. A logic circuit according to claim I, wherein said input circuit means comprises at least one input PNP-type bipolar transistor (TI) receiving said input signal at a base thereof, and a fourth NPN-type bipolar transistor (T2) connected between said terminals of said power supply, a base of which is connected to an emitter of said input bipolar transistor and an emitter of which is connected to said base of first bipolar transistor in said first internal circuit means.

9. A logic circuit according to claim 8, wherein said forward voltage of said level-shift circuit means, said second internal circuit means and said output circuit means is higher than a forward voltage of said input circuit means and said first internal circuit means.

I0. A logic circuit according to claim 9, wherein said input circuit means comprises a plurality of parallel-connected input NPN-type bipolar transistors (TII, TI2).

II. A logic circuit according to claim I0, wherein said level-shift circuit includes a diode (D2).

I2. A logic circuit according to claim II, wherein said level-shift circuit means includes at least two series-connected diodes (D3, D4) each having a same forward voltage as that of said diode in said level-shift circuit.

I3. A logic circuit according to claim I, wherein said input circuit means comprises an input multi-emitter bipolar transistor, said multi-emitter receiving a plurality of input signals ($SIN_A$, $SIN_B$).

I4. A logic circuit according to claim I, wherein said input circuit means comprises at least one diode (DI5, DI6) receiving said input signal (SIN).

I5. A logic circuit according to claim I, further comprising off buffer circuit means (4) series-connected to said output circuit means.

I6. A logic circuit according to claim I, further comprising pull-down circuit means series-connected to said second internal circuit means.

# Fig. 1

# Fig. 2

$$V1 \fallingdotseq V_{BE4} + V_{BE5}$$
$$V2 < V_{BE2} + V_{BE3} + V_{F2}$$

## Fig. 3

## Fig. 6

# Fig. 4

Fig. 5a    T2

Fig. 5b    T3

Fig. 5c    T4

Fig. 5d    T5

$t_0$    $t_1$    $t_2$  $(t_3)$  $t_4$

0 253 555

# Fig. 7

# Fig. 8